# DEMANDE DE BREVET EUROPEEN

(11) **EP 2 924 449 A1**
(43) Date de publication de la demande: **30.09.2015**
(21) Numéro de dépôt: 15159316.7
(22) Date de dépôt: 17.03.2015
(51) Int. Cl.: G01R 15/12, G01R 1/067, G01R 13/02, G01R 31/302, G01R 1/04

(54) **APPAREIL DE MESURE ET DE CONTRÔLE ÉLECTRIQUES**

(30) Priorité: 25.03.2014 FR 1452537
(71) Demandeur: Société Anonyme des Ets. CATU, 92220 Bagneux (FR)
(72) Inventeur: Flasquin, Gilles, 92350 LE PLESSIS ROBINSON (FR); Lesueur, Bruno, 78140 VELIZY-VILLACOUBLAY (FR); Monange, Cyrile, 92120 MONTROUGE (FR); Pauzat, Vincent, 27430 ANDE (FR)
(74) Mandataire: Santarelli

(57) **Abrégé**

L'invention concerne un appareil de mesure/contrôle électriques comportant un boîtier-afficheur (3) ayant deux bornes de connexion (24, 26) et étant configuré pour afficher les résultats des mesures/contrôles, un boîtier-support (2) ayant plusieurs bornes de connexion (16-18), et au moins deux organes de contact électrique (25, 80) configurés pour être reliés directement ou indirectement aux bornes de connexion dudit boîtier-support dans au moins une première configuration dudit appareil (1), dans laquelle ledit boîtier-support et lesdits organes de contact sont configurés pour effectuer des mesures/contrôles et lesdits boîtiers support et afficheur sont configurés pour communiquer ensemble pour afficher le résultat des mesures/contrôles sur ledit boîtier afficheur et, dans une deuxième configuration de fonctionnement, lesdits organes de contact sont configurés pour être connectés aux dites bornes de connexion dudit boîtier-afficheur, ledit boîtier-afficheur et lesdits organes de contact sont configurés pour effectuer des mesures/contrôles et ledit boîtier-afficheur est configuré pour afficher le résultat des mesures/contrôles.

## Description

### DOMAINE DE L'INVENTION

L'invention a trait au domaine général de l'instrumentation électrique, et en particulier aux appareils de mesure et de contrôle électriques, configurés pour effectuer des mesures/contrôles par exemple de tension électrique et/ou d'isolement d'un circuit électrique hors tension et/ou de continuité ohmique d'un circuit électrique hors ou sous tension.

### ARRIERE PLAN TECHNOLOGIQUE

On connaît de la demande de brevet américain US 2004/0160410 un appareil pourvu d'un multimètre portable et d'un afficheur déporté, distinct du multimètre. L'appareil est en outre pourvu de deux testeurs à pointe de touche configurés pour être connectés à des bornes de connexion que comporte le multimètre portable.

Le multimètre et les testeurs sont configurés pour effectuer des mesures sur un circuit électrique notamment sous tension tandis que l'afficheur déporté est configuré pour afficher le résultat de la mesure sur un écran que cet afficheur comporte.

Le multimètre portable et l'afficheur déporté présentent des bornes de communication respectives configurées pour communiquer ensemble afin d'assurer le transfert d'informations entre ceux-ci, de manière filaire ou non-filaire.

Dans un mode de réalisation, le multimètre, l'afficheur et les deux testeurs forment quatre pièces distinctes. Les informations reçues par les pointes de touches sont communiquées au multimètre par l'intermédiaire de câbles dédiés qui relient respectivement les testeurs au multimètre, pour y être traitées. Le multimètre envoie une information représentative de la mesure vers l'afficheur déporté, par l'intermédiaire des bornes de communication, pour y être affichée.

L'afficheur déporté peut par exemple être fixé à un bracelet porté autour du poignet d'un utilisateur de l'appareil, ou monté sur un gant que porte cet utilisateur.

Dans un autre mode de réalisation, l'afficheur déporté et l'un des deux testeurs sont formés en une seule pièce. La communication des informations est identique à celle décrite ci-dessus.

L'utilisateur de l'appareil tient alors dans sa main la pièce formée de la pointe de touche et de l'afficheur déporté.

L'appareil décrit dans le document US 2004/0160410 permet, grâce à l'afficheur déporté, de visualiser en toute sécurité les résultats des mesures effectuées à l'aide des testeurs et du multimètre.

### OBJET DE L'INVENTION

L'invention vise à fournir un appareil de mesure et de contrôle électriques plus performant et polyvalent, tout en étant particulièrement simple, commode et économique.

L'invention a ainsi pour objet un appareil de mesure et de contrôle électriques, configuré pour effectuer des mesures et/ou contrôles électriques selon différentes configurations de fonctionnement dudit appareil, lequel comporte :
- un boîtier-support comportant au moins deux bornes de connexion ;
- au moins deux organes de contact électrique configurés pour être reliés, directement ou indirectement, auxdites bornes de connexion dudit boîtier-support dans au moins une première configuration de fonctionnement dudit appareil ; et
- un boîtier-afficheur configuré pour afficher les résultats des mesures et/ou contrôles électriques ;
avec, dans ladite au moins une première configuration de fonctionnement dudit appareil, ledit boîtier-support et lesdits organes de contact qui sont configurés pour effectuer des mesures et/ou contrôles électriques et lesdits boîtier-support et boîtier-afficheur qui sont configurés pour communiquer ensemble pour afficher le résultat des mesures et/ou contrôles électriques sur ledit boîtier afficheur ; ledit appareil étant caractérisé en ce que :
- ledit boîtier-afficheur comporte deux bornes de connexion ; et
- dans une deuxième configuration de fonctionnement dudit appareil, lesdits organes de contact sont configurés pour être connectés aux dites bornes de connexion dudit boîtier-afficheur, avec ledit boîtier-afficheur et lesdits organes de contact qui sont configurés pour effectuer des mesures et/ou contrôles électriques et ledit boîtier-afficheur qui est en outre configuré pour afficher le résultat des mesures et/ou contrôles électriques.

L'appareil selon l'invention permet avantageusement, d'une part, l'utilisation du boîtier-afficheur ensemble avec les organes de contact en tant que module de mesure/contrôle/affichage autonome (deuxième configuration) ; et d'autre part, l'utilisation du boîtier-support ensemble avec les organes de contact en tant que module de mesure/contrôle et du boîtier-afficheur en tant qu'afficheur (première(s) configuration(s)).

L'appareil présente ainsi une deuxième configuration de fonctionnement dans laquelle le boîtier-support n'est pas utilisé, tandis que le boîtier-afficheur est utilisé à la fois pour les mesures/contrôles et pour l'affichage du résultat de ces mesures/contrôles.

Un utilisateur de l'appareil selon l'invention a ainsi la possibilité, en fonction des mesures/contrôles à réaliser, d'adapter la configuration de fonctionnement de l'appareil. Il peut par exemple avoir dans les mains un unique module autonome, formé du boîtier-afficheur et des organes de contact, qui est capable à la fois d'effectuer les mesures/contrôles et de les afficher sans aucune connexion au boîtier-support. Il peut par exemple avoir dans les mains uniquement les organes de contact reliés, directement ou non, au boîtier-support, lequel est par exemple posé sur le sol avec le boîtier-afficheur (qui ne sert alors que d'afficheur). Il peut par exemple avoir dans les mains le boîtier afficheur (ne servant que comme afficheur) et les organes de contact reliés, directement ou non, au boîtier-support qui est par exemple posé sur le sol.

L'appareil selon l'invention, lequel est modulaire et dont les modules sont formés notamment par le boîtier-support et le boîtier-afficheur, est ainsi particulièrement commode à manipuler par un utilisateur car l'appareil est capable de s'adapter à de nombreuses situations de mesure/contrôle, par exemple une situation qui nécessite de nombreux déplacements sur un niveau d'un bâtiment et où l'utilisation du module autonome est adaptée.

On notera que l'on entend ici par connexion entre un organe de contact et une borne du boîtier-afficheur ou du boîtier-support le fait que cet organe de contact est relié directement au boîtier respectif.

On notera également que l'on entend ici par organe de contact un organe configuré pour établir un contact électrique entre un circuit électrique et une borne de connexion de l'un quelconque des boîtier-support et boîtier-afficheur. Généralement, un tel organe de contact est formé d'un cordon ayant à une extrémité une borne de raccordement à raccorder à un des boîtiers et, à une extrémité opposée, un élément métallique configuré pour être mis au contact d'un élément conducteur du circuit électrique. Cet élément métallique peut être formé par exemple d'une pointe de touche ou d'une pince dite crocodile. L'organe de contact peut aussi être formé d'un unique élément à pointe de touche, sans cordon.

On notera en outre que l'on entend ici par circuit électrique un système pourvu d'au moins un élément conducteur d'une énergie électrique alternative ou continue. Il peut s'agir d'une installation électrique monophasée, biphasée, triphasée ou continue, ou bien d'un appareillage électrique.

L'appareil selon l'invention est donc particulièrement simple, ergonomique, et économique.

Selon des caractéristiques préférées, simples, commodes et économiques de l'appareil selon l'invention :
- ledit boîtier-afficheur présente au moins un clavier de commande configuré pour sélectionner une fonction de mesure/contrôle parmi plusieurs fonctions prédéterminées et commander ladite mesure et/ou ledit contrôle sélectionné dans une configuration de fonctionnement déterminée dudit appareil ;
- ledit boîtier-afficheur comporte un organe de commande configuré pour établir une liaison électrique directe entre les deux dites bornes de connexion dudit boîtier-afficheur dans ladite au moins une première configuration de fonctionnement dudit appareil et interrompre ladite liaison électrique directe entre les deux dites bornes de connexion dudit boîtier-afficheur dans ladite deuxième configuration de fonctionnement dudit appareil ;

- ledit organe de commande est formé par un commutateur piloté et par une unité de commande et de contrôle configurée pour piloter ledit commutateur ;
- ledit boîtier-afficheur comporte un module de mesure et/ou contrôle électriques interconnecté entre lesdites bornes de connexion dudit boîtier-afficheur dans ladite deuxième configuration de fonctionnement dudit appareil ;
- dans une dite première configuration de fonctionnement dudit appareil, les deux dits organes de contacts sont configurés pour être connectés à deux dites bornes de connexion dudit boîtier-support ;
- ledit boîtier-support comporte un logement configuré pour recevoir ledit boîtier-afficheur ;
- dans une dite première configuration de fonctionnement dudit appareil, un dit organe de contact est configuré pour être connecté à une dite borne de connexion dudit boîtier-support, un autre dit organe de contact est configuré pour être connecté à une dite borne de connexion dudit boîtier-afficheur et lesdits boîtier-support et boîtier-afficheur sont configurés pour être connectés entre eux par leur autre dite borne de connexion respective, avec ledit boîtier-support et lesdits organes de contact qui sont configurés pour effectuer des mesures et/ou contrôles électriques et ledit boîtier-afficheur qui est configuré pour afficher le résultat des mesures et/ou contrôles électriques ;
- ledit appareil comporte un câble de connexion reliant lesdites autres bornes de connexion respectives desdits boîtier-afficheur et boîtier-support ;
- ledit appareil est configuré pour effectuer des mesures et/ou contrôles de tension électrique aux bornes d'un circuit électrique, et/ou des mesures et/ou contrôles d'isolement électrique d'un circuit électrique hors

tension, et/ou des mesures et/ou contrôles de continuité ohmique d'un circuit électrique hors ou sous tension ;
- ledit boîtier-afficheur comporte un organe de contact électrique intégré sur une de ses bornes de connexion ;
- lesdits boîtier-support et boîtier-afficheur comportent des bornes de communication et des modules d'émission/réception d'ondes qui sont configurés pour que lesdites bornes de communication respectives communiquent entre elles ; et/ou
- lesdits modules d'émission/réception d'ondes sont configurés pour que lesdites bornes de communication respectives communiquent par radiofréquences de manière bidirectionnelle.

### BREVE DESCRIPTION DES DESSINS

On va maintenant poursuivre l'exposé de l'invention par la description d'un exemple de réalisation, donné ci-après à titre illustratif et non limitatif, en référence aux dessins annexés sur lesquels :
- la figure 1 représente schématiquement un appareil de mesure et de contrôle électriques, pourvu d'un boîtier-support et d'un boîtier-afficheur, dans une configuration de repos où le boîtier-afficheur est logé dans le boîtier-support et où aucune mesure et/ou aucun contrôle ne sont effectués ;
- la figure 2 représente schématiquement et partiellement les éléments composant le boîtier-support et le boîtier-afficheur de l'appareil illustré sur la figure 1 ;
- la figure 3 représente schématiquement l'appareil illustré sur la figure 1, dans une première configuration de fonctionnement dans laquelle une fonction de mesure/contrôle de tension aux bornes d'un circuit électrique sous tension est mise en oeuvre;
- la figure 4 représente schématiquement l'appareil illustré sur les figures 1 et 3, dans une autre première configuration de fonctionnement dans laquelle une fonction de contrôle d'isolement d'un circuit électrique hors tension est mise en oeuvre;
- la figure 5 représente schématiquement l'appareil illustré sur les figures 1, 3 et 4, dans une deuxième configuration de fonctionnement dans laquelle une fonction de contrôle de continuité ohmique d'un circuit électrique hors ou sous tension est mise en oeuvre ; et
- la figure 6 représente schématiquement l'appareil illustré sur les figures 1 et 3 à 5, dans encore une autre première configuration de fonctionnement dans laquelle la fonction de mesure/contrôle de tension aux bornes d'un circuit électrique sous tension est mise en oeuvre.

### DESCRIPTION DETAILLEE DES FIGURES

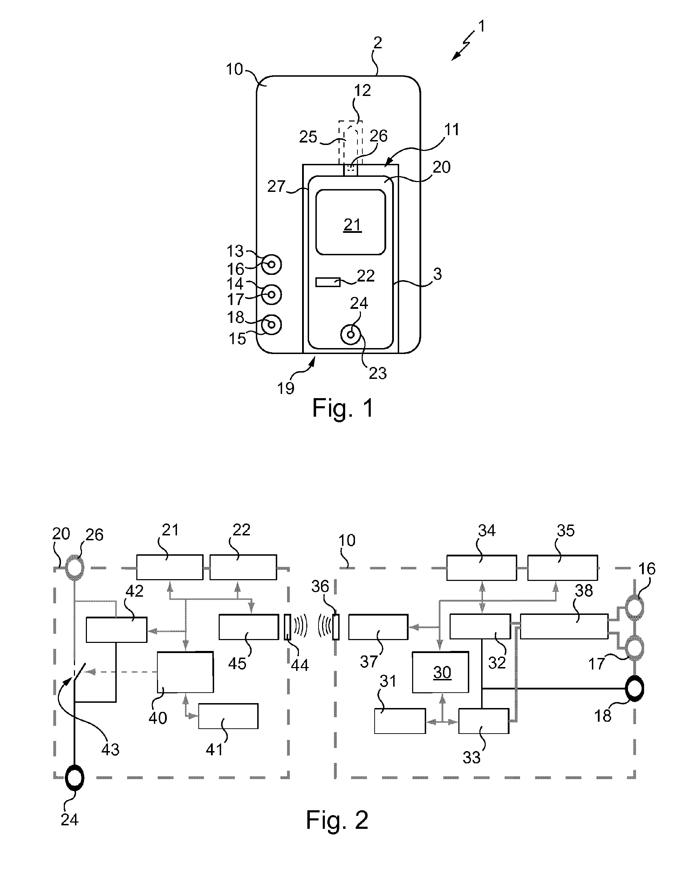

La figure 1 illustre un appareil de mesure et de contrôle électriques 1, ici dans une configuration dite de repos où l'appareil 1 n'effectue aucune mesure et aucun contrôle.

L'appareil 1 comporte un boîtier-support 2 et un boîtier-afficheur 3 distinct du boîtier-support 2.

Le boîtier-support 2 comporte un corps ici de forme générale sensiblement parallélépipédique ainsi qu'un logement 11 ménagé dans ce corps 10.

Ce logement 11 débouche sur une face frontale du corps 10 et sur un côté 19 de ce corps 10 et est prévu pour recevoir le boîtier-afficheur 3.

Le corps 10 comporte en outre une fente d'insertion 12 accessible depuis le logement 11.

Le boîtier-support 2 comporte en outre une pluralité de bornes de raccordement, ici trois, référencées 13, 14 et 15, chacune pourvue d'une borne de connexion électrique référencée respectivement 16, 17 et 18.

Ces bornes de raccordement 13, 14 et 15 sont ménagées dans le corps 10.

Le boîtier-support 2 comporte en outre des voyants lumineux et un haut-parleur (non représentés).

Le boîtier-afficheur 3 comporte un corps 20 de forme générale sensiblement parallélépipédique ainsi qu'un écran d'affichage 21 et un clavier de commande 22 disposés sur une face frontale de ce corps 20.

Le boîtier-afficheur 3 comporte également une borne de raccordement 23 ménagée dans le corps 20 et pourvue d'une borne de connexion 24.

Le boîtier-afficheur 3 comporte en outre une autre borne de connexion 26 intégrée dans le corps 20, sur un côté 27 de ce corps 20, à l'opposé de la borne de connexion 24.

L'appareil 1 comporte plusieurs organes de contact dont un seul est illustré sur la figure 1. L'organe de contact illustré est formé par une pointe de touche 25 monté sur le boîtier-afficheur 3.

La pointe de touche 25 est ici intégrée au corps 27 du boîtier-afficheur 3, en saillie sur le côté 27 de ce corps 20, et est reliée directement électriquement à la borne de connexion 26 intégrée au corps 20.

Le corps 20 du boîtier-afficheur 3 est configuré pour venir se loger dans le logement 11 ménagé dans le corps 10 du boîtier-support 2, la pointe de touche 25 du boîtier-afficheur 3 étant configurée pour s'introduire dans la fente 12 ménagée dans le corps 10 du boîtier-support 2.

Dans sa configuration de repos, l'appareil 1 est ainsi particulièrement commode à stocker et à déplacer pour se rendre par exemple sur un chantier où des mesures et/ou des contrôles électriques sont à réaliser.

L'appareil 1 illustré sur la figure 1 est ici configuré pour effectuer différentes mesures et/ou différents contrôles électriques selon différentes configurations de fonctionnement de cet appareil 1.

Plus précisément, l'appareil 1 est ici configuré pour effectuer des mesures et/ou contrôles de tension électrique aux bornes d'un circuit électrique, d'isolement électrique d'un circuit électrique hors tension, et de continuité ohmique d'un circuit électrique hors tension ou sous tension.

On notera que l'on entend ici par circuit électrique un système pourvu d'au moins un élément conducteur d'une énergie électrique alternative ou continue. Il peut s'agir d'une installation électrique monophasée, biphasée, triphasée ou continue, ou bien d'un appareillage électrique.

Le clavier de commande 22 du boîtier-afficheur 3 est ici configuré pour sélectionner des fonctions déterminées de mesures et/ou de contrôles à effectuer et envoyer des ordres de commande pour les réaliser.

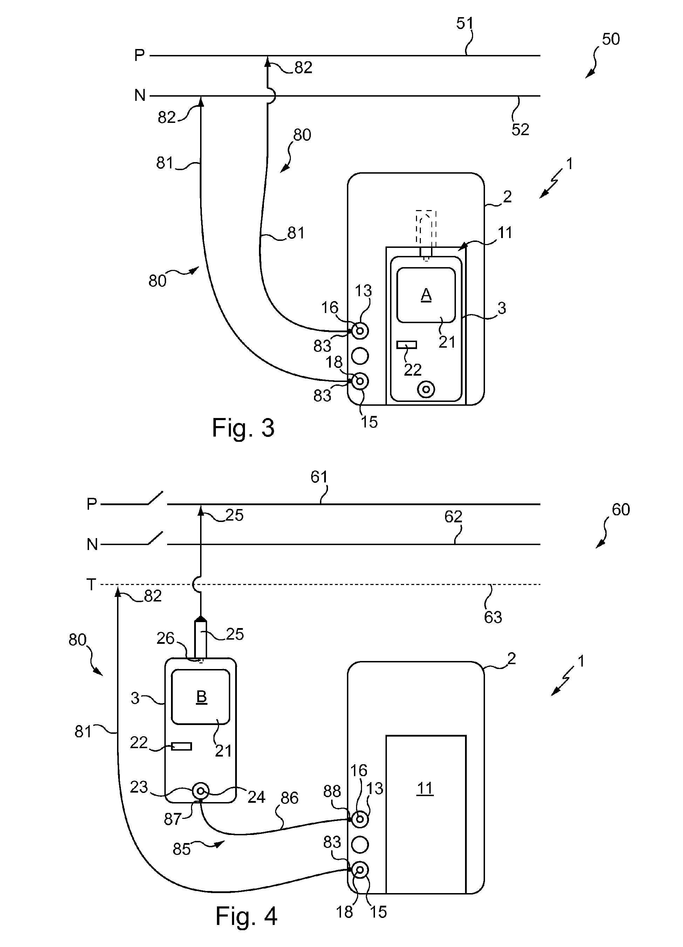

Selon une première configuration de fonctionnement de l'appareil 1, un utilisateur peut effectuer des mesures et/ou contrôles à l'aide d'organes de contact qu'il tient dans ses mains et en disposant l'ensemble boîtier-support 2 et boîtier-afficheur 3 logé dans le boîtier-support 2 par exemple sur le sol, les organes de contact étant connectés, c'est-à-dire reliés directement, au boîtier-support 2 (figure 3).

Selon une autre première configuration de fonctionnement de l'appareil 1, un utilisateur peut effectuer des mesures et/ou contrôles à l'aide de la pointe de touche 25 du boîtier-afficheur 3 qu'il tient dans sa main et à l'aide d'un autre organe de contact qu'il tient dans son autre main et en disposant le boîtier-support 2 par exemple sur le sol, la pointe de touche 25 et l'autre organe de contact étant reliés indirectement au boîtier-support 2 (figure 4).

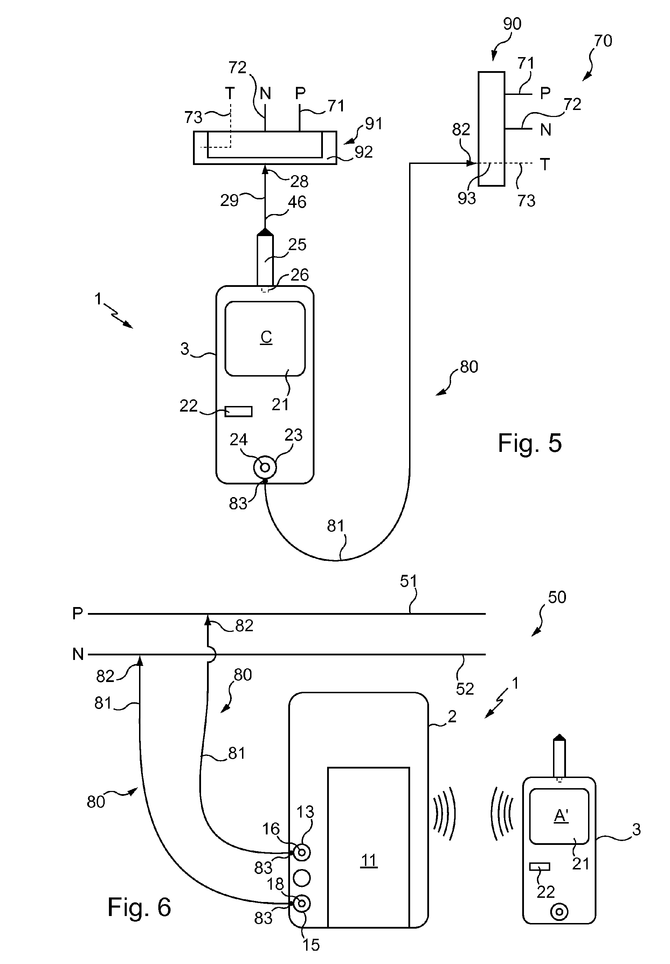

Selon encore une autre première configuration de fonctionnement de l'appareil 1, un utilisateur peut effectuer des mesures et/ou contrôles à l'aide d'organes de contact qu'il tient dans ses mains et en disposant le boîtier-support 2 seul par exemple sur le sol, les organes de contact étant connectés, c'est-à-dire reliés directement, au boîtier-support 2 (figure 6). Le cas échéant, l'utilisateur peut aussi porter le boîtier-afficheur 3, par exemple dans la main ou à la ceinture.

Selon une deuxième configuration de fonctionnement de l'appareil 1, un utilisateur peut effectuer des mesures et/ou contrôles à l'aide de la pointe de touche 25 du boîtier-afficheur 3 qu'il tient dans sa main et à l'aide d'un autre organe de contact qu'il tient dans son autre main, lequel organe de contact étant connecté, c'est-à-dire relié directement, au boîtier-afficheur 3. Le boîtier-support 2 n'est pas utilisé dans cette deuxième configuration de fonctionnement de l'appareil 1.

On va maintenant décrire plus en détail des éléments composant le boîtier-support 2 et le boîtier-afficheur 3 de l'appareil 1 en référence à la figure 2.

Le boîtier-support 2 comporte une unité de contrôle et de commande 30, laquelle est pourvue d'un système de traitement de données comportant un microprocesseur, ou un microcontrôleur, muni de mémoires permettant la mise en oeuvre d'étapes de procédés de calculs/mesures/contrôles et la mémorisation de données en fonction des mesures/contrôles à effectuer.

Le boîtier-support 2 comporte un module d'alimentation électrique 31 connectée à l'unité de contrôle et de commande 30. Il peut s'agir par exemple d'une ou de plusieurs unités de stockage d'énergie, notamment des batteries.

Le boîtier-support 2 comporte ici un module de mesure/contrôle de tension 32 et un module de mesure/contrôle d'isolement électrique 33, connectés chacun à la fois à l'unité de contrôle et de commande 30, à la borne de connexion 18 et aux bornes de connexions 16 et 17 au travers d'un module de protection 38 que comporte ce boîtier-support 2.

Le module de protection 38 est ici configuré notamment pour protéger l'appareil 1 et l'utilisateur si, lors de mesures/contrôles effectués normalement sur un circuit électrique hors tension, ce dernier était accidentellement remis sous tension.

Chacune des bornes de connexions 16 à 18 du boîtier-support 2 sont ici configurées pour être connectées électriquement à un câble ou conducteur d'un circuit électrique.

Le boîtier-support 2 comporte ici un module d'avertissement visuel 34 et un module d'avertissement sonore 35 chacun connecté à l'unité de contrôle et de commande 30. Il peut par exemple s'agir respectivement des voyants lumineux et du haut-parleur mentionnés ci-dessus.

Le boîtier-support 2 comporte une borne de communication 36 ici par radiofréquences ainsi qu'un module d'émission/réception d'ondes 37 connecté à la fois à la borne de communication 36 et à l'unité de contrôle et de commande 30.

On notera que les interconnexions entre l'unité de contrôle et de commande, les différents modules et les bornes de connexion et de communication du boîtier-support 2 sont ici réalisées grâce à un circuit imprimé sur lequel sont assemblés ces différents éléments.

Le boîtier-afficheur 3 comporte quant à lui une unité de contrôle et de commande 40, laquelle est pourvue d'un système de traitement de données comportant un microprocesseur, ou un microcontrôleur, muni de mémoires permettant la mise en oeuvre d'étapes de procédés de calculs/mesures/contrôles et la mémorisation de données en fonction des mesures/contrôles à effectuer.

Le boîtier-afficheur 3 comporte un module d'alimentation électrique 41 connectée à l'unité de contrôle et de commande 40. Il peut s'agir par exemple d'une ou de plusieurs unités de stockage d'énergie, notamment des batteries.

Le boîtier-afficheur 3 comporte un module de mesure/contrôle de continuité ohmique 42 connecté à l'unité de contrôle et de commande 40 et interconnecté entre les bornes de connexion 24 et 26 du boîtier-afficheur 3.

Le boîtier-afficheur 3 comporte un commutateur piloté 43 formé ici par un interrupteur interconnecté entre les bornes de connexion 24 et 26, en parallèle du module de mesure/contrôle de continuité ohmique 42.

L'unité de contrôle et de commande 40 est configurée pour piloter le commutateur 43 entre une position fermée dans laquelle une liaison électrique est créée entre les bornes de connexion 24 et 26, au travers du commutateur 43, et une position ouverte dans laquelle cette liaison électrique est interrompue et le module de mesure/contrôle de continuité ohmique est sur le chemin électrique entre les bornes de connexion 24 et 26.

L'ensemble comportant l'unité de contrôle et de commande 40 et le commutateur piloté 43 forme ici un organe de commande.

L'écran 21 et le clavier de commande 22 du boîtier-afficheur 3 sont connectés à l'unité de contrôle et de commande 40.

Le boîtier-afficheur 3 comporte une borne de communication 44 ici par radiofréquences ainsi qu'un module d'émission/réception d'ondes 45 connecté à la fois à la borne de communication 44 et à l'unité de contrôle et de commande 40.

L'appareil 1 est ici configuré de sorte que les modules d'émission/réception d'ondes 37 et 45 respectivement du boîtier-support 2 et du boîtier-afficheur 3 permettent aux bornes de communication respectives 36 et 44 de communiquer ensemble par radiofréquences de manière bidirectionnelle, avec une portée par exemple jusqu'à environ 30m.

On notera que les interconnexions entre l'unité de contrôle et de commande, les différents modules et les bornes de connexion et de communication du boîtier-afficheur 3 sont ici réalisées grâce à un circuit imprimé sur lequel sont assemblés ces différents éléments.

On va maintenant décrire plus en détail différentes configurations de fonctionnement de l'appareil 1, mises en oeuvre dans différentes fonctions de mesures/contrôles, en référence aux figures 3 à 6.

La figure 3 illustre la mise en oeuvre d'une fonction de mesures/contrôles de tension aux bornes d'un circuit électrique 50 sous tension, l'appareil 1 étant dans une première configuration de fonctionnement.

Le circuit électrique 50 est ici pourvu d'un câble de phase 51, noté aussi P, et d'un câble de neutre 52, noté aussi N.

Le boîtier-afficheur 3 est logé dans le logement 11 du boîtier-support 2.

L'appareil 1 comporte deux organes de contact 80 similaires, pourvus chacun d'un cordon 81 enveloppant un fil conducteur et, à une première extrémité du cordon 81, une pointe de touche 82 configurée pour établir un contact électrique avec un câble du circuit électrique 50.

Chaque organe de contact 80 présente en outre, à une deuxième extrémité du cordon 81, opposée à sa première extrémité, une fiche de raccordement 83 configurée pour être raccordée sur une borne de raccordement du boîtier-support 2.

Plus précisément, un organe de contact 80 a sa pointe de touche 82 au contact avec le câble de phase 51 et sa fiche de raccordement 83 raccordée sur la borne de raccordement 13 du boîtier-support 2, de sorte à établir une liaison électrique entre le câble de phase 51, la pointe de touche 82 et la borne de connexion 16.

L'appareil 1 comporte un autre organe de contact 80 dont la pointe de touche 82 est au contact du câble de neutre 52 et dont la fiche de raccordement 83 est raccordée à la borne de raccordement 15 du boîtier-support 2, de sorte à établir une connexion électrique entre le câble de neutre 52, la pointe de touche 82 et la borne de connexion 18.

Les organes de contact 80 sont ici connectés, c'est-à-dire qu'ils sont directement reliés aux bornes de connexions respectives 16 et 18 du boîtier-support 2.

La sélection de la fonction mesure/contrôle de tension aux bornes du circuit électrique 50 est faite à l'aide du clavier de commande 22 et de l'écran 21 du boîtier-afficheur 3 logé dans le boîtier-support 2.

L'unité de contrôle et de commande 40 du boîtier-afficheur 3 envoie un ordre de mesure/contrôle à l'unité de contrôle et de commande 30 du boîtier-support 2 par l'intermédiaire des modules d'émission/réception d'ondes 45 et 37 respectifs et des bornes de communication 44 et 36 respectives.

L'unité de contrôle et de commande 30 et le module de mesure/contrôle de tension 32 du boîtier-support 2 sont configurés pour réaliser les mesures/contrôles de tension aux bornes du circuit électrique 50.

On notera qu'il s'agit ici d'une mesure de valeur efficace vraie de tension, communément notée « True Root Mean Square » ou TRMS en terminologie anglo-saxonne.

Les résultats des mesures/contrôles sont transmis par l'unité de contrôle et de commande 30 du boîtier-support 2, par l'intermédiaire des modules 37 et 45 respectifs et des bornes de communication 36 et 44 respectives, à l'unité de contrôle et de commande 40 du boîtier-afficheur 3, laquelle est configurée pour afficher ces résultats, noté A, sur l'écran 21 du boîtier-afficheur 3.

Dans cette première configuration de fonctionnement de l'appareil 1, on notera que le boîtier-support 2 et les deux organes de contact 80 sont configurés pour effectuer les mesures/contrôles tandis que le boîtier-afficheur 3 est configuré pour afficher les résultats de ces mesures/contrôles, en plus de permettre la sélection d'une fonction prédéterminée de mesures/contrôles.

Dans cette première configuration de fonctionnement, l'utilisateur de l'appareil 1 tient dans ses mains les organes de contact 80 tandis que l'ensemble formé du boîtier-support 2 et du boîtier-afficheur 3 logé dans le boîtier-support 2 est par exemple posé au sol.

La figure 4 illustre la mise en oeuvre d'une fonction de mesures/contrôles d'isolement électrique d'un circuit électrique 60 hors tension, l'appareil 1 étant dans une autre première configuration de fonctionnement.

Le circuit électrique 60 présente, de manière similaire au circuit électrique 50 illustré sur la figure 3, un câble de phase 61 et un câble de neutre 62. Le circuit électrique 60 présente en outre un câble dit de mise à la terre 63, noté T.

Le boîtier-afficheur 3 est hors du logement 11 du boîtier-support 2.

L'appareil 1 comporte un premier organe de contact 80 similaire à ceux décrits en référence à la figure 3.

La pointe de touche 82 de cet organe de contact 80 est au contact du câble de terre 63 et sa fiche de raccordement 83 est raccordée sur la borne de raccordement 15 du boîtier-support 2 pour établir une liaison électrique entre le câble de terre 63, la pointe de touche 82 et la borne de connexion 18.

Cet organe de contact 80 est donc ici connecté, en d'autres termes relié directement, à la borne de connexion 18 du boîtier-support 2.

L'appareil 1 comporte un autre organe de contact formé par la pointe de touche intégrée 25 au boîtier-afficheur 3, laquelle est mise au contact du câble de phase 61.

La représentation de cette mise en contact est schématique sur la figure 4 et en pratique, l'utilisateur tient dans une main le boîtier-afficheur 3 et vient poser l'extrémité libre de la pointe de touche 25 sur le câble de phase 61.

L'appareil 1 comporte également un câble de connexion 85 pourvu d'un cordon 86, d'une fiche de raccordement 87 a une première extrémité de ce cordon 86 et d'une autre fiche de raccordement 88 a une deuxième extrémité de ce cordon 86, opposée à sa première extrémité.

La fiche de raccordement 87 est raccordée sur la borne de raccordement 23 du boîtier-afficheur 3 et la fiche de raccordement 88 est raccordée sur la borne de raccordement 13 du boîtier-support 2.

Le câble de connexion 85 permet ainsi d'établir une liaison électrique entre la borne de connexion 24 du boîtier-afficheur 3 et la borne de connexion 16 du boîtier-support 2.

La sélection de la fonction de mesures/contrôles d'isolement du circuit électrique 60 est faite à l'aide du clavier de commande 22 et de l'écran 21 du boîtier-afficheur 3.

L'unité de contrôle et de commande 40 du boîtier-afficheur 3 pilote le commutateur 43 pour qu'il prenne sa position fermée de sorte à établir une liaison électrique directe entre la borne de connexion 26 à laquelle est connectée la pointe de touche 25 et la borne de connexion 24 à laquelle est connecté le câble de connexion 85.

Ainsi la pointe de touche 25, qui forme un organe de contact, est reliée indirectement à la borne de connexion 16 du boîtier-support 2.

L'unité de contrôle et de commande 40 du boîtier-afficheur 3 envoie un ordre de mesure/contrôle à l'unité de contrôle et de commande 30 du boîtier-support 2 par l'intermédiaire des modules d'émission/réception d'ondes 45 et 37 respectifs et des bornes de communication 44 et 36 respectives.

L'unité de contrôle et de commande 30 et le module de mesure/contrôle d'isolement 33 du boîtier-support 2 sont configurés pour réaliser les mesures/contrôles d'isolement du circuit électrique 60.

Les résultats des mesures/contrôles sont transmis par l'unité de contrôle et de commande 30 du boîtier-support 2, par l'intermédiaire des modules 37 et 45 respectifs et des bornes de communication 36 et 44 respectives, à l'unité de contrôle et de commande 40 du boîtier-afficheur 3, laquelle est configurée pour afficher ces résultats, noté B, sur l'écran 21 du boîtier-afficheur 3.

Dans cette autre première configuration de fonctionnement de l'appareil 1, on notera que le boîtier-support 2, l'organe de contact 80 et la pointe de touche 25 du boîtier-afficheur 3, ensemble avec son commutateur 43 et le câble de connexion 85, sont configurés pour effectuer les mesures/contrôles tandis que le boîtier-afficheur 3 est configuré pour afficher les résultats de ces mesures/contrôles, en plus de permettre la sélection d'une fonction prédéterminée de mesures/contrôles.

Dans cette autre première configuration de fonctionnement, l'utilisateur de l'appareil 1 tient dans ses mains l'organe de contact 80 et le boîtier-afficheur 3 tandis que le boîtier-support 2 est par exemple posé au sol.

La figure 5 illustre la mise en oeuvre d'une fonction de mesures/contrôles de continuité ohmique d'un circuit électrique 70 hors ou sous tension, l'appareil 1 étant dans une deuxième configuration de fonctionnement.

Le circuit électrique 70 comporte, comme le circuit 60 illustré ci-dessus, un câble de phase 71, un câble de neutre 72 et un câble de terre 73 configuré pour mettre à la masse le circuit électrique 70.

Le circuit électrique 70 comporte ici une prise électrique 90 connectée à chacun des câbles 71 à 73. Cette prise électrique 90 comporte de manière conventionnelle un plot de terre 93 connecté au câble de terre 73.

Le circuit électrique 70 comporte ici une source lumineuse 91 pourvue d'une enveloppe métallique 92. Cette source lumineuse 91 est connectée à chacun des câbles 71 à 73 du circuit 70. L'enveloppe métallique 92 est reliée au câble de terre 73.

Le boîtier-afficheur 3 est hors du logement 11 du boîtier-support 2 et est utilisé dans cette deuxième configuration de manière autonome.

L'appareil 1 comporte un premier organe de contact 80 similaire à ceux décrits en référence à la figure 3.

La pointe de touche 82 de cet organe de contact 80 est au contact du plot de terre 93 de la prise 90 et sa fiche de raccordement 83 est raccordée sur la borne de raccordement 23 du boîtier-afficheur 3 pour établir une liaison électrique directe entre le câble de terre 73 via le plot de terre 93, la pointe de touche 82 et la borne de connexion 24.

Cet organe de contact 80 est ici connecté, en d'autres termes relié directement, à la borne de connexion 24 du boîtier-afficheur 3.

L'appareil 1 comporte en outre une perche 29 munie, à une extrémité, d'une pointe de touche 28 et, à une autre extrémité opposée, d'un embout de raccordement mécanique et électrique 46 monté à l'extrémité libre de la pointe de touche 25 du boîtier-afficheur 3.

Une telle perche 29 est ici utilisée pour permettre l'accès à l'enveloppe métallique 92 de la source lumineuse 91, qui se trouve par exemple en hauteur dans le cas d'un luminaire monté au plafond. Cette perche 29 permet ainsi de prolonger la pointe de touche 25.

L'ensemble formé de la pointe de touche 25 du boîtier-afficheur 3 et de la perche 29 forment ici un autre organe de contact de l'appareil 1, qui est mis au contact de l'enveloppe métallique 92 de la source lumineuse 91 grâce à la pointe de touche 28 de la perche 29 et qui est ainsi relié à la borne de connexion 26 du boîtier-afficheur 3 via la pointe de touche 25.

La sélection de la fonction de mesures/contrôles de continuité ohmique du circuit électrique 70 est faite à l'aide du clavier de commande 22 et de l'écran 21 du boîtier-afficheur 3.

L'unité de contrôle et de commande 40 du boîtier-afficheur 3 pilote le commutateur 43 pour qu'il prenne sa position ouverte de sorte d'une part, à interrompre une liaison électrique directe entre la borne de connexion 26 à laquelle est connectée la pointe de touche 25 et la borne de connexion 24 à laquelle est connecté l'organe de contact 80 et d'autre part, à interconnecter le module de mesure/contrôle de continuité 42 du boîtier-afficheur 3 entre ses bornes de connexion 24 et 26.

L'unité de contrôle et de commande 40 et le module de continuité ohmique 42 sont alors configurés pour effectuer les mesures/contrôles de continuité ohmique sur le circuit 70, entre la prise 90 et la source lumineuse 91, sans nécessiter l'emploi des modules d'émission/réception d'ondes 45 et 37 et des bornes de communication 44 et 36.

Les résultats des mesures/contrôles, notés C, sont directement affichés par l'unité de contrôle et de commande 40 sur l'écran 21 du boîtier-afficheur 3, sans nécessiter non plus l'emploi des modules d'émission/réception d'ondes 45 et 37 et des bornes de communication 44 et 36.

Plus généralement, aucune communication n'est nécessaire entre le boîtier-support 2 et le boîtier-afficheur 3 dans cette deuxième configuration de fonctionnement de l'appareil 1.

Dans cette deuxième configuration de fonctionnement de l'appareil 1, on notera que le boîtier-afficheur 3, l'organe de contact 80 et la pointe de touche 25 sont configurés pour effectuer les mesures/contrôles tandis que le boîtier-afficheur 3 est en outre configuré pour afficher les résultats de ces mesures/contrôles, en plus de permettre la sélection d'une fonction prédéterminée de mesures/contrôles.

Dans cette deuxième configuration de fonctionnement, l'utilisateur de l'appareil 1 tient dans ses mains l'organe de contact 80 et le boîtier-afficheur 3 tandis que le boîtier-support 2 n'est pas utilisé.

L'utilisateur de l'appareil 1 peut ainsi facilement se déplacer d'un point à un autre en ne tenant uniquement dans ses mains que le boîtier-afficheur 3 sur lequel est intégrée la pointe de touche 25, voire la perche 29 et, l'organe de contact 80 muni d'un cordon 81 et d'une pointe de touche 82.

La figure 6, qui est sensiblement similaire à la figure 3, illustre la mise en oeuvre de la fonction de mesures/contrôles de tension aux bornes du circuit électrique 50 sous tension, l'appareil 1 étant dans encore une autre première configuration de fonctionnement.

La seule différence avec l'appareil illustré sur la figure 3 est que le boîtier-afficheur 3 est ici en dehors du logement 11 du boîtier-support 2.

L'appareil 1 comporte deux organes de contact 80 connectés à l'identique de ceux illustrés sur la figure 3.

La sélection de la fonction de mesures/contrôles de tension aux bornes du circuit électrique 50 est faite à l'aide du clavier de commande 22 et de l'écran 21 du boîtier-afficheur 3.

L'unité de contrôle et de commande 40 du boîtier-afficheur 3 envoie un ordre de mesure/contrôle à l'unité de contrôle et de commande 30 du boîtier-support 2 par l'intermédiaire des modules d'émission/réception d'ondes 45 et 37 respectifs et des bornes de communication 44 et 36 respectives. Les ondes radioélectriques sont représentées sur la figure 6.

L'unité de contrôle et de commande 30 et le module de mesure/contrôle de tension 32 du boîtier-support 2 sont configurés pour réaliser les mesures/contrôles de tension aux bornes du circuit électrique 50.

Les résultats des mesures/contrôles sont transmis par l'unité de contrôle et de commande 30 du boîtier-support 2, par l'intermédiaire des modules 37 et 45 respectifs et des bornes de communication 36 et 44 respectives, à l'unité de contrôle et de commande 40 du boîtier-afficheur 3, laquelle est configurée pour afficher ces résultats, noté A', sur l'écran 21 du boîtier-afficheur 3.

Dans cette autre première configuration de fonctionnement de l'appareil 1, le boîtier-support 2 et les deux organes de contact 80 sont configurés pour effectuer les mesures/contrôles tandis que le boîtier-afficheur 3 est configuré pour afficher les résultats de ces mesures/contrôles, en plus de permettre la sélection d'une fonction prédéterminée de mesures/contrôles.

Dans cette autre première configuration de fonctionnement, l'utilisateur de l'appareil 1 tient dans ses mains les organes de contact 80 tandis que le boîtier-support 2 est par exemple posé au sol. L'utilisateur peut aussi avoir le boîtier-afficheur 3 dans ses mains, ou l'avoir accroché par exemple à la ceinture.

Dans des variantes non illustrées :
- la première configuration de fonctionnement de l'appareil, illustrée sur la figure 3, où le boîtier-afficheur est logé dans le boîtier-support, peut permettre d'effectuer des mesures/contrôles d'isolement plutôt que des mesures/contrôles de tension ; et il en est de même de la configuration de fonctionnement illustrée sur la figure 6 ;
- l'autre première configuration de fonctionnement de l'appareil, illustrée sur la figure 4, où le boîtier-afficheur est hors du boîtier-support, peut permettre d'effectuer des mesures/contrôles de tension plutôt que des mesures/contrôles d'isolement ;
- lors de la sélection de la fonction de mesures/contrôles d'isolement, la fonction de mesures/contrôles de tension peut également être mise en oeuvre par exemple afin de prévenir de la remise sous tension du circuit électrique ;
- la pointe de touche intégrée au boîtier-afficheur peut être utilisée avec ou sans perchette ;
- la pointe de touche intégrée au boîtier-afficheur peut être amovible ou fixe ;
- les organes de contact sont pourvus de pinces dites crocodiles ou mâchoires ou encore dauphins, voire d'embouts dits grip-fils, plutôt que de pointes de touche ;
- le boîtier-afficheur peut être dépourvu de pointe de touche intégrée et présenter plutôt une borne de raccordement similaire à celle située du côté opposé à la pointe de touche ;
- le boîtier-afficheur est pourvu d'un écran tactile et le clavier de commande est directement accessible sur cet écran ;
- chacun des deux boîtiers est pourvu d'un clavier de commande respectif ;
- le boîtier-support est dépourvu d'un logement ménagé dans son corps mais présente plutôt des organes de fixation du boîtier-afficheur pour que ce dernier puisse y être monté de manière amovible ;
- le boîtier-support comporte un module d'avertissement par vibrations plutôt qu'un haut-parleur ;
- le boîtier-afficheur comporte un commutateur manuel, formé par exemple par un bouton d'actionnement ménagé sur le corps du boîtier-afficheur, plutôt qu'un commutateur piloté ;
- le boîtier-afficheur est dépourvu de commutateur piloté et présente plutôt quatre bornes de connexion, dont deux sont directement reliées électriquement entre elles et dont les deux autres sont séparées par le module de mesure/contrôle de continuité ohmique, lequel est interconnecté entre ces deux autres bornes de connexions ;
- le boîtier-afficheur est dépourvu de commutateur piloté et présente plutôt trois bornes de connexion, dont une première borne qui est directement reliée électriquement à une deuxième borne et une troisième borne qui est connectée au module de mesure/contrôle de continuité ohmique, lequel est en outre connecté à la deuxième borne avec, le cas échéant, le boîtier-afficheur qui comporte en outre un détrompeur mécanique configuré pour assurer l'utilisation du chemin électrique prédéterminé (première-deuxième bornes ou deuxième-troisième bornes) suivant la fonction de mesures/contrôles sélectionnée ;
- les modules d'émission/réception des boîtier-support et boîtier-afficheur sont configurés pour que leur borne de communication respective communiquent par ondes optiques plutôt que par ondes radioélectriques ; et/ou
- les bornes de communication respectives du boîtier-support et du boîtier-afficheur sont configurées pour présenter une portée bien supérieure à 30 m, par exemple jusqu'à 100 m.

On rappelle plus généralement que l'invention ne se limite pas aux exemples décrits et représentés.

## Revendications

1. Appareil de mesure et de contrôle électriques, configuré pour effectuer des mesures et/ou contrôles électriques selon différentes configurations de fonctionnement dudit appareil (1), lequel comporte :
- un boîtier-support (2) comportant au moins deux bornes de connexion (16-18) ;
- au moins deux organes de contact électrique (25, 80) configurés pour être reliés, directement ou indirectement, auxdites bornes de connexion (16-18) dudit boîtier-support (2) dans au moins une première configuration de fonctionnement dudit appareil (1) ; et
- un boîtier-afficheur (3) configuré pour afficher les résultats des mesures et/ou contrôles électriques ;
avec, dans ladite au moins une première configuration de fonctionnement dudit appareil (1), ledit boîtier-support (2) et lesdits organes de contact (80) qui sont configurés pour effectuer des mesures et/ou contrôles électriques et lesdits boîtier-support (2) et boîtier-afficheur (3) qui sont configurés pour communiquer ensemble pour afficher le résultat des mesures et/ou contrôles électriques sur ledit boîtier afficheur (3) ; ledit appareil (1) étant **caractérisé en ce que** :
- ledit boîtier-afficheur (3) comporte deux bornes de connexion (24, 26) ; et
- dans une deuxième configuration de fonctionnement dudit appareil (1), lesdits organes de contact (25, 80) sont configurés pour être connectés aux dites bornes de connexion (24, 26) dudit boîtier-afficheur (3), avec ledit boîtier-afficheur (3) et lesdits organes de contact (25, 80) qui sont configurés pour effectuer des mesures et/ou contrôles électriques et ledit boîtier-afficheur (3) qui est en outre configuré pour afficher le résultat des mesures et/ou contrôles électriques.

2. Appareil selon la revendication 1, **caractérisé en ce que** ledit boîtier-afficheur (3) présente au moins un clavier de commande (22) configuré pour sélectionner une fonction de mesure/contrôle parmi plusieurs fonctions prédéterminées et commander ladite mesure et/ou ledit contrôle sélectionné dans une configuration de fonctionnement déterminée dudit appareil (1).

3. Appareil selon l'une des revendications 1 et 2, **caractérisé en ce que** ledit boîtier-afficheur (3) comporte un organe de commande (40, 43) configuré pour établir une liaison électrique directe entre les deux dites bornes de connexion (24, 26) dudit boîtier-afficheur (3) dans ladite au moins une première configuration de fonctionnement dudit appareil (1) et interrompre ladite liaison électrique directe entre les deux dites bornes de connexion (24, 26) dudit boîtier-afficheur dans ladite deuxième configuration de fonctionnement dudit appareil (1).

4. Appareil selon la revendication 3, **caractérisé en ce que** ledit organe de commande est formé par un commutateur piloté (43) et par une unité de commande et de contrôle (40) configurée pour piloter ledit commutateur (43).

5. Appareil selon l'une des revendications 3 et 4, **caractérisé en ce que** ledit boîtier-afficheur (3) comporte un module de mesure et/ou contrôle électriques (42) interconnecté entre lesdites bornes de connexion (24, 26) dudit boîtier-afficheur (3) dans ladite deuxième configuration de fonctionnement dudit appareil (1).

6. Appareil selon l'une quelconque des revendications 1 à 5, **caractérisé en ce que**, dans une dite première configuration de fonctionnement dudit appareil (1), les deux dits organes de contacts (80) sont configurés pour être connectés à deux dites bornes de connexion (16-18) dudit boîtier-support (2).

7. Appareil selon la revendication 6, **caractérisé en ce que** ledit boîtier-support (2) comporte un logement (11) configuré pour recevoir ledit boîtier-afficheur (3).

8. Appareil selon l'une quelconque des revendications 1 à 7, **caractérisé en ce que**, dans une dite première configuration de fonctionnement dudit appareil, un dit organe de contact (80) est configuré pour être connecté à une dite borne de connexion (16) dudit boîtier-support (2), un autre dit organe de contact (25) est configuré pour être connecté à une dite borne de connexion (26) dudit boîtier-afficheur (3) et lesdits boîtier-support (2) et boîtier-afficheur (3) sont configurés pour être connectés entre eux par leur autre dite borne de connexion respective (18, 24), avec ledit boîtier-support (2) et lesdits organes de contact (25, 80) qui sont configurés pour effectuer des mesures et/ou contrôles électriques et ledit boîtier-afficheur (3) qui est configuré pour afficher le résultat des mesures et/ou contrôles électriques.

9. Appareil selon la revendication 8, **caractérisé en ce qu'**il comporte un câble de connexion (85) reliant lesdites autres bornes de connexion respectives (18, 24) desdits boîtier-afficheur (3) et boîtier-support (2).

10. Appareil selon l'une quelconque des revendications 1 à 9, **caractérisé en ce qu'**il est configuré pour effectuer des mesures et/ou contrôles de tension électrique aux bornes d'un circuit électrique (50), et/ou des mesures et/ou contrôles d'isolement électrique d'un circuit électrique hors tension (60), et/ou des mesures et/ou contrôles de continuité ohmique d'un circuit électrique hors ou sous tension (70).

11. Appareil selon l'une quelconque des revendications 1 à 10, **caractérisé en ce que** ledit boîtier-afficheur (3) comporte un organe de contact électrique intégré (25) sur une de ses bornes de connexion (26).

12. Appareil selon l'une quelconque des revendications 1 à 11, **caractérisé en ce que** lesdits boîtier-support (2) et boîtier-afficheur (3) comportent des bornes de communication (36, 44) et des modules d'émission/réception d'ondes (37, 45) qui sont configurés pour que lesdites bornes de communication respectives (36, 44) communiquent entre elles.

13. Appareil selon la revendication 12, **caractérisé en ce que** lesdits modules d'émission/réception d'ondes (37, 45) sont configurés pour que lesdites bornes de communication respectives (36, 44) communiquent par radiofréquences de manière bidirectionnelle.
